# EUROPEAN PATENT APPLICATION

(11) **EP 3 722 457 A1**
(43) Date of publication of application: **14.10.2020**
(21) Application number: 19168949.6
(22) Date of filing: 12.04.2019
(51) Int. Cl.: C23C 16/04, C23C 16/26, C23C 16/30, C23C 16/48, C23C 16/56, G03F 1/22, G03F 7/20, H01L 21/285

(54) **METHOD AND APPARATUS FOR FORMING A PATTERNED LAYER OF MATERIAL**

(71) Applicant: ASML Netherlands B.V., 5500 AH Veldhoven (NL)
(72) Inventor: DRUZHININA, Tamara, 5500 AH Veldhoven (NL); OVERKAMP, Jim, Vincent, 5500 AH Veldhoven (NL); POLYAKOV, Alexey, Olegovich, 5500 AH Veldhoven (NL); COENEN, Teis, Johan, 5500 AH Veldhoven (NL); KURGANOVA, Evgenia, 5500 AH Veldhoven (NL); CIOBICA, Ionel, Mugurel, 5500 AH Veldhoven (NL)
(74) Representative: ASML Netherlands B.V.

(57) **Abstract**

Methods and apparatus for forming a patterned layer of material are disclosed. In one arrangement, a selected portion of a surface of a substrate is irradiated during a deposition process, the irradiation being such as to locally drive the deposition process in the selected portion and thereby form a layer of deposited material in a pattern defined by the selected portion. The deposited material is annealed to modify the deposited material.

## Description

### FIELD

The present invention relates to methods and apparatus for forming a patterned layer of material.

### BACKGROUND

As semiconductor manufacturing processes continue to advance, the dimensions of circuit elements have continually been reduced while the amount of functional elements, such as transistors, per device has been steadily increasing, following a trend commonly referred to as 'Moore's law'. To keep up with Moore's law the semiconductor industry is seeking technologies that enable creation of increasingly smaller features.

Various deposition technologies exist for fabricating two-dimensional materials. Such deposition technologies include chemical vapor deposition (CVD) and atomic layer deposition (ALD) for example. There is interest in using such deposition technologies to form device structures such as circuit elements as part of semiconductor manufacturing processes. A challenge has been that the deposition technologies usually require high temperatures to work efficiently. High temperatures can degrade or damage previously deposited layers and/or restrict the range of previously deposited layers that can be used. The previously deposited layers must be formed so that they can withstand the high temperatures to an acceptable degree, for example by having melting points above the temperatures reached during the deposition process. A further challenge has been to achieve acceptably high throughput. It is difficult to configure deposition processes such as CVD and ALD so that deposition occurs quickly while maintaining high quality in the deposited material.

### SUMMARY

It is an object of the invention to provide alternative or improved methods and apparatus for forming patterned layers.

According to an aspect, there is provided a method of forming a patterned layer of material, comprising: irradiating a selected portion of a surface of a substrate during a deposition process, the irradiation being such as to locally drive the deposition process in the selected portion and thereby form a layer of deposited material in a pattern defined by the selected portion; and annealing the deposited material to modify the deposited material.

Thus, a method is provided in which a modified deposited material is produced through a combination of an irradiation process to drive a deposition process and a separate annealing process. In an embodiment, the modification of the deposited material comprises increasing a degree of crystallinity of the deposited material. Providing a separate annealing process reduces demands on the deposition step. The deposition step can be configured for example to deposit material at a relatively low quality (e.g. in an amorphous rather than crystalline state). Reducing demands on the deposition step may make it possible to perform the deposition step more quickly and/or at lower temperatures than would otherwise be possible. Performing the deposition at lower temperatures reduces the risk of damage to previously deposited layers. The annealing can be performed locally or in a pulsed manner to reduce heating of sensitive portions of previously deposited layers. Performing the deposition more quickly increases throughput.

In an embodiment, the annealing of the deposited material comprises: a first step in which all of the substrate is preheated to a target temperature above room temperature; and a second step, subsequent to the first step, in which a selected local region of the substrate is heated to a temperature above the target temperature, the selected local region being smaller than the whole substrate. The annealing may sequentially heat each of one or more further selected local regions to anneal deposited material in each further selected local region. The preheating reduces the amount of heating that needs to be applied by the localized heating, thereby improving the speed of localized heating and the throughput of the annealing process.

In an embodiment, a first radiation source is used to provide the irradiation to drive the deposition process; a second radiation source is used to anneal the deposited material; and the first radiation source is different to the second radiation source. In an example of such an embodiment, the first radiation source and the second radiation source irradiate the substrate from opposite sides of the substrate. Irradiating the substrate from different sides provides more flexibility in how the respective irradiation systems can be positioned and configured. In other embodiments, the first radiation source and the second radiation source irradiate the substrate from the same side of the substrate.

In an embodiment, the same radiation source is used at different times to provide the irradiation to drive the deposition process and irradiation to anneal the deposited material. This approach avoids the need for separate apparatus to be provided for the two processes. In an example of such an embodiment, the irradiation to drive the deposition process is performed with a finer spatial resolution than the irradiation to anneal the deposited material. Thus, the lower spatial resolution requirements of the annealing process are exploited to adopt a faster, lower resolution irradiation mode, thereby improving throughput.

According to a further aspect, there is provided a method of forming a patterned layer of material, comprising: irradiating a selected portion of a surface of a substrate during a deposition process, the irradiation being such as to locally drive the deposition process in the selected portion and thereby form a layer of deposited material in a pattern defined by the selected portion, wherein: the irradiation is performed using radiation having a wavelength of less than 100nm in combination with one or more of the following: an electron beam; radiation having a wavelength in the range of 100nm to 400nm; and laser radiation.

Thus, a method is provided in which two different forms of irradiation are used to drive the deposition process. The combination of different forms of irradiation provides greater flexibility for optimizing the driving of the deposition process. There is a wider range of modes of interaction between the irradiation and material in the vicinity of the selected portion, thereby providing enhanced scope for generating reactive species to drive the deposition process efficiently.

According to a further aspect, there is provided a method of forming a patterning layer of material, comprising: irradiating a selected portion of a surface of a substrate with electromagnetic radiation having a wavelength of less than 100nm during a deposition process, the irradiation being such as to locally drive the deposition process in the selected portion and thereby cause the deposition process to form a layer of material in a pattern defined by the selected portion, wherein the deposited material comprises boron.

Thus, a method is provided which uses EUV radiation to drive a deposition process to deposit boron. Boron, for example in the form of a borophene, is more transparent to EUV and more stable than many other materials, such as carbon, that can be deposited using an EUV driven deposition process. Use of boron makes it possible to use a scanning EUV illumination mode, which for other materials would be compromised by excessive plasma-induced etching of deposited material.

According to a further aspect, there is provided a method of forming a patterned layer of material, comprising: using a deposition process to form a layer of material; and irradiating a selected portion of the layer of material with radiation comprising an electron beam, the irradiation being such as to cause removal of the layer of material in the selected portion and thereby form a layer of material in a pattern defined by the selected portion.

The use of an electron beam to perform removal of material provides an alternative approach to electromagnetic radiation assisted removal techniques and is capable of achieving high spatial resolution.

According to a further aspect, there is provided an apparatus for forming a patterned layer of material, comprising: an irradiation system configured to irradiate a selected portion of a surface of a substrate during a deposition process, the irradiation being such as to locally drive the deposition process in the selected portion and thereby form a layer of deposited material in a pattern defined by the selected portion; and an annealing system configured to anneal the deposited material to modify the deposited material.

According to a further aspect, there is provided an apparatus for forming a patterned layer of material, comprising: a first irradiation system configured to irradiate a selected portion of a surface of a substrate during a deposition process with radiation having a wavelength of less than 100nm; and a second irradiation system configured to irradiate the selected portion of the surface of the substrate during the deposition process with one or more of the following: an electron beam; radiation having a wavelength in the range of 100nm to 400nm; and laser radiation, wherein: the first irradiation system and the second irradiation system are configured such that the irradiation locally drives the deposition process in the selected portion to cause formation of a layer of deposited material in a pattern defined by the selected portion.

### BRIEF DESCRIPTION OF THE DRAWINGS

Embodiments of the invention will now be described, by way of example only, with reference to the accompanying schematic drawings, in which:
Figure 1 depicts a first example of a lithographic system comprising a lithographic apparatus and a radiation source;
Figure 2 depicts a second example of a lithographic system comprising a lithographic apparatus and a radiation source;
Figure 3 schematically depicts irradiation of a selected portion on a substrate during a first step of an atomic layer deposition process;
Figure 4 schematically depicts a step in the atomic layer deposition process subsequent to the step depicted in Figure 3;
Figure 5 schematically depicts a lithographic apparatus providing radiation to an environment control system according to an embodiment;
Figure 6 schematically depicts an apparatus for forming a patterned layer of material comprising an irradiation system and an annealing system;
Figure 7 schematically depicted an apparatus for forming a patterned layer of material comprising a first irradiation system and a second irradiation system; and
Figure 8 schematically depicts plasma-induced etching of deposited material in the wake of a scanning EUV radiation beam.

### DETAILED DESCRIPTION

A lithographic apparatus is a machine constructed to apply a desired pattern onto a substrate. A lithographic apparatus can be used, for example, in the manufacture of integrated circuits (ICs). A lithographic apparatus may, for example, project a pattern at a patterning device (e.g., a mask) onto a layer of radiation-sensitive material (resist) provided on a substrate.

To project a pattern on a substrate a lithographic apparatus may use electromagnetic radiation. The wavelength of this radiation determines the minimum size of features which are patterned on the substrate. Typical wavelengths currently in use are 365 nm (i-line), 248 nm, 193 nm and 13.5 nm. A lithographic apparatus which uses extreme ultraviolet (EUV) radiation, having a wavelength of less than 100nm, optionally in the range of 5-100 nm, optionally within a range of 4 nm to 20 nm, for example 6.7 nm or 13.5 nm, may be used to form smaller features on a substrate than a lithographic apparatus which uses, for example, radiation with a wavelength of 193 nm.

In the present document, the terms "radiation" and "beam" are used to encompass all types of electromagnetic radiation unless stated otherwise, including ultraviolet radiation (e.g. with a wavelength of 365, 248, 193, 157 or 126 nm) and EUV (extreme ultra-violet radiation, e.g. having a wavelength in the range of about 5-100 nm), as well as electron beam radiation.

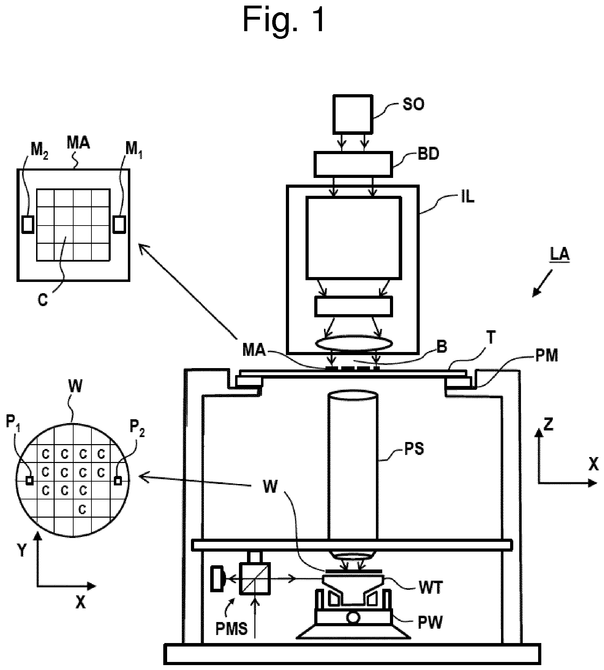

Figure 1 schematically depicts a lithographic apparatus LA. The lithographic apparatus LA includes an illumination system (also referred to as illuminator) IL configured to condition a radiation beam B (e.g., UV radiation, DUV radiation or EUV radiation), a mask support (e.g., a mask table) MT constructed to support a patterning device (e.g., a mask) MA and connected to a first positioner PM configured to accurately position the patterning device MA in accordance with certain parameters, a substrate support (e.g., a wafer table) WT constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US6952253, which is incorporated herein by reference.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support MT, and is patterned by the pattern (design layout) present on patterning device MA. Having traversed the mask MA, the radiation beam B passes through the projection system PS, which focuses the beam onto a target portion C of the substrate W. With the aid of the second positioner PW and a position measurement system IF, the substrate support WT can be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks PI, P2. Although the substrate alignment marks PI, P2 as illustrated occupy dedicated target portions, they may be located in spaces between target portions. Substrate alignment marks PI, P2 are known as scribe-lane alignment marks when these are located between the target portions C.

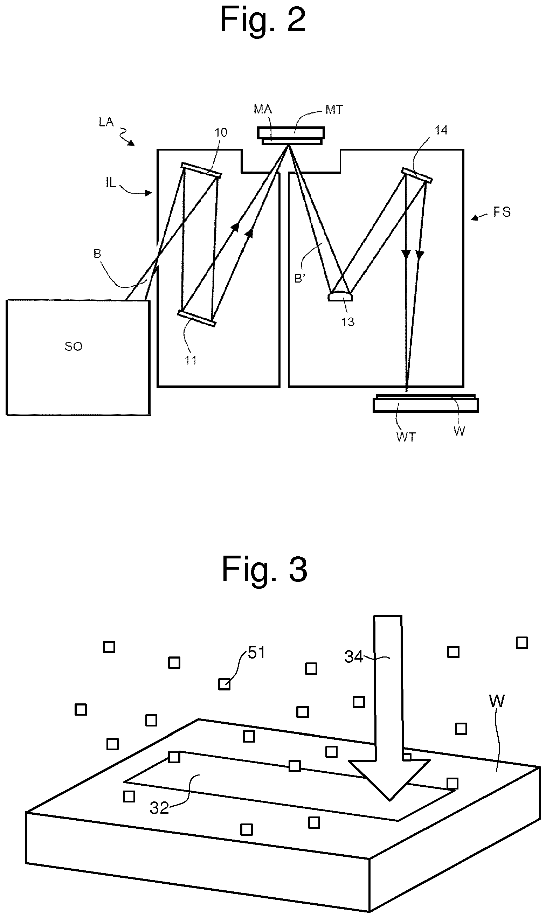

Figure 2 shows a lithographic system comprising a radiation source SO and a lithographic apparatus LA. The radiation source SO is configured to generate an EUV radiation beam B and to supply the EUV radiation beam B to the lithographic apparatus LA. The lithographic apparatus LA comprises an illumination system IL, a support structure MT configured to support a patterning device MA (e.g., a mask), a projection system PS and a substrate table WT configured to support a substrate W.

The illumination system IL is configured to condition the EUV radiation beam B before the EUV radiation beam B is incident upon the patterning device MA. Thereto, the illumination system IL may include a facetted field mirror device 10 and a facetted pupil mirror device 11. The faceted field mirror device 10 and faceted pupil mirror device 11 together provide the EUV radiation beam B with a desired cross-sectional shape and a desired intensity distribution. The illumination system IL may include other mirrors or devices in addition to, or instead of, the faceted field mirror device 10 and faceted pupil mirror device 11.

After being thus conditioned, the EUV radiation beam B interacts with the patterning device MA. As a result of this interaction, a patterned EUV radiation beam B' is generated. The projection system PS is configured to project the patterned EUV radiation beam B' onto the substrate W. For that purpose, the projection system PS may comprise a plurality of mirrors 13,14 which are configured to project the patterned EUV radiation beam B' onto the substrate W held by the substrate table WT. The projection system PS may apply a reduction factor to the patterned EUV radiation beam B', thus forming an image with features that are smaller than corresponding features on the patterning device MA. For example, a reduction factor of 4 or 8 may be applied. Although the projection system PS is illustrated as having only two mirrors 13,14 in Figure 2, the projection system PS may include a different number of mirrors (e.g. six or eight mirrors).

The substrate W may include previously formed patterns. Where this is the case, the lithographic apparatus LA aligns the image, formed by the patterned EUV radiation beam B', with a pattern previously formed on the substrate W.

A relative vacuum, i.e. a small amount of gas (e.g. hydrogen) at a pressure well below atmospheric pressure, may be provided in the radiation source SO, in the illumination system IL, and/or in the projection system PS.

The radiation source SO may be a laser produced plasma (LPP) source, a discharge produced plasma (DPP) source, a free electron laser (FEL) or any other radiation source that is capable of generating EUV radiation.

As mentioned in the introductory part of the description, although there is interest in using deposition technologies such as CVD or ALD to fabricate two-dimensional materials as part of a semiconductor manufacturing process, there have been several practical challenges. A first challenge is the relatively high temperatures that are required in typical deposition implementations, which could damage previously deposited layers. A second challenge is the relatively slow speed of deposition in the typical deposition implementations, which could limit manufacturing throughput. Embodiments described below address either or both of these challenges.

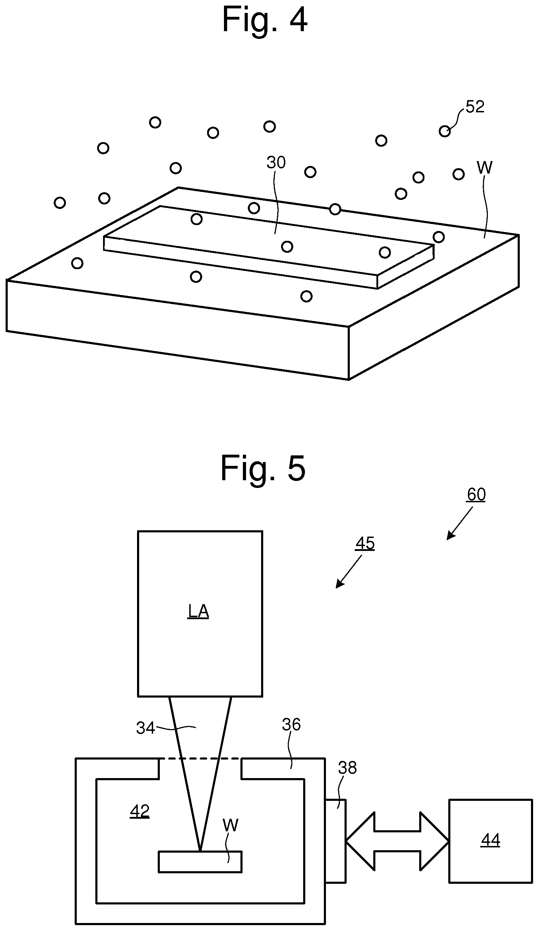

Figures 3 and 4 schematically depict formation of a patterned layer of material 30 according to a method of an embodiment. As depicted in Figure 3, the method comprises irradiating 34 a selected portion 32 of a surface of a substrate W during a deposition process. In an embodiment, the deposition process is configured to form a monolayer (or multiple monolayers if the deposition process is repeated). In the embodiment shown, the deposition process is an atomic layer deposition process. In other embodiments, a different deposition process or combination of deposition processes is used, including for example one or more of the following independently or in combination: atomic layer deposition; chemical vapor deposition; plasma-enhanced chemical vapor deposition; epitaxy; sputtering; and electron beam-induced deposition. The formation of the patterned layer of material 30 may constitute a step in a method of forming at least one layer of a device to be manufactured, such as a semiconductor device.

In an embodiment, the irradiation is performed with radiation that is capable of locally driving the deposition process (e.g. atomic layer deposition process). In an embodiment, the radiation comprises, consists essentially of, or consists of any type of EUV radiation (having a wavelength less than 100nm) that is capable of locally driving the deposition process (e.g. atomic layer deposition process). The use of EUV radiation provides high spatial resolution. In some other embodiments, the irradiation is performed with radiation comprising, consisting essentially of, or consisting of, higher wavelength radiation, optionally in combination with an immersion liquid, as described below. The higher wavelength radiation may be in the range of 100nm to 400nm (including DUV radiation).

The irradiation locally drives the deposition process (in the embodiment shown, the atomic layer deposition process) in the selected portion 32 and thereby causes the formation of a layer of deposited material 30 (see Figure 4) in a pattern defined by the selected portion 32. A pattern is thus formed without needing any resist. No processing to remove a resist is therefore required, which reduces the risk of damage to the patterned layer of material 30. In contrast to traditional lithography-based semiconductor manufacturing processes, instead of being used to break or cross-link molecules in a resist, radiation is being used to drive one or more chemical reactions involved in the deposition process (e.g. atomic layer deposition process).

Atomic layer deposition is a known thin-film deposition technique in which each of at least two chemicals (which may be referred to as precursor materials) are made to react with the surface of a material in a sequential, self-limiting, manner. In contrast to chemical vapor deposition, the two precursor materials are not normally present simultaneously above the substrate W.

In at least some embodiments using atomic layer deposition, the atomic layer deposition comprises at least a first step and a second step. In the first step, an example of which is depicted in Figure 3, a first precursor material 51 is made to react with a surface of a substrate W. In the second step, an example of which is depicted in Figure 4, a second precursor material 52 is made to react with the substrate W in a region where the first precursor 51 reacted with the substrate W in the first step (in this example the selected portions 32).

Figure 5 schematically depicts an apparatus 60 for performing the method. The apparatus 60 thus forms a patterned layer of material. The apparatus 60 comprises an irradiation system. The irradiation system may comprise a lithographic apparatus LA. The lithographic apparatus LA irradiates the selected portion 32 by projecting a patterned radiation beam from a patterning device MA onto the substrate W. The lithographic apparatus LA may be configured as described above with reference to Figure 1 (e.g. when the irradiation comprises DUV radiation and/or immersion lithography is required) or as described above with reference to Figure 2 (e.g. when the irradiation comprises EUV radiation).

In an embodiment, the lithographic apparatus LA is configured to perform immersion lithography. In such an embodiment, the atomic layer deposition process may comprise a step in which the selected portion 32 is irradiated while the selected portion 32 is in contact with an immersion liquid. Thus, for example, the atomic layer deposition process may comprise a first step comprising adsorption of a precursor from a gaseous precursor material to the substrate W and a second step in which the adsorbed precursor is modified in the selected portion 32 (e.g. to remove a by-product of the adsorption process) by irradiation through the immersion liquid. Any by-product produced by the irradiation through the immersion liquid can conveniently be carried away by flow of the immersion liquid. In an embodiment, the irradiated substrate W is subsequently dried and any further required processing is performed on the dried substrate W.

In an embodiment, an environment control system 45 is provided. The environment control system 45 allows the composition of the environment 42 above the substrate W to be controlled in such a way as to allow the deposition process (e.g. atomic layer deposition process) to proceed. In an embodiment, the environment control system 45 comprises a chamber 36 to provide a sealed environment 42 including the selected portion 32 of the surface of the substrate W. In some embodiments, all of the substrate W will be within the chamber 36 during the deposition process (e.g. atomic deposition process). In an embodiment, a materials exchange system 38 (e.g. a port into the chamber 36 and associated valves and/or conduits) is provided that allows materials to be added to and removed from the sealed environment 42 to allow different compositional environments to be established within the sealed environment 42. Materials may be provided to and from the materials exchange system 38 by a flow manager 44. The flow manager 44 may comprise any suitable combination of reservoirs, ducting, valves, sinks, pumps, control systems, and/or other components necessary to provide the required flows of materials into and out of the chamber 36. The different compositional environments achieved in this way correspond to different respective stages of the atomic layer deposition process. In some embodiments, the materials added to and removed from the chamber 36 are gaseous, thereby providing compositional environments consisting of different combinations of gases. In an embodiment in which one or more steps of the deposition process (e.g. atomic layer deposition process) are performed by irradiating the substrate W through an immersion liquid, the environment control system 45 may be configured to allow switching between a state in which a controlled liquid environment is maintained above the substrate W (e.g. during exposure in an immersion lithography mode) and a state in which a controlled gaseous environment is maintained above the substrate W (e.g. during adsorption of a precursor from a gaseous precursor material).

In some embodiments, the driving of the deposition process (e.g. atomic layer deposition process) in the selected portion 32 comprises driving a chemical reaction involving a precursor material. The precursor material will be provided as part of the compositional environment established above the substrate during the irradiation. The driving of the chemical reaction may cause the chemical reaction to proceed at a faster rate than would be the case in the absence of the irradiation. Alternatively, the chemical reaction may be such that it would not occur at all in the absence of the irradiation. In an embodiment, the chemical reaction is endothermic and the irradiation provides the energy necessary to allow the chemical reaction to proceed. In some embodiments, the chemical reaction is at least partially driven by heat generated in the substrate W by the irradiation. Thus, the chemical reaction being driven by the irradiation may comprise a chemical reaction that requires an elevated temperature to proceed or which proceeds more rapidly at elevated temperatures. In some embodiments, the chemical reaction comprises a photochemical reaction driven by the irradiation. Thus, at least one species involved in the chemical reaction directly absorbs a photon from the irradiation and the absorption of the photon allows the chemical reaction to proceed. In some embodiments, the photochemical reaction comprises a multi-photon photochemical reaction involving absorption of two or more photons by each of at least one species involved in the photochemical reaction. The requirement for two or more photons to be absorbed makes the chemical reaction much more sensitive to variations in the intensity of the irradiation (i.e. the rate of the chemical reaction varies much more strongly as a function of intensity) than would be the case for single photon photochemical reactions. The increased sensitivity to intensity provides improved lateral contrast. In an embodiment, a combination of a photochemical reaction and radiation induced heating is used to provide a well-defined process window in which the chemical reaction is driven locally to produce the pattern. In an embodiment, the chemical reaction is driven by a plasma generated by interaction between the radiation and the substrate W, a layer formed on the substrate W, and/or a gas present above the substrate. In an embodiment, the generated plasma is generated in a localized region defined by the irradiation. In an embodiment, the chemical reaction is driven by electrons provided by the irradiation. The electrons may comprise photoelectrons or secondary electrons (electrons generated by inelastic scattering events of a photoelectron). In an embodiment, photons absorbed by the substrate W may provide energetic electrons near the surface of the substrate W that participate in the deposition process. In embodiments where a combination of electromagnetic radiation and an e-beam is used, a portion of the deposition process may be driven by electrons from the e-beam.

In the example of Figures 3 and 4, the substrate W is irradiated in the first step only of the atomic layer deposition. In other embodiments, the irradiation of the selected portion 32 is performed during the second step only or during the first step and the second step. In embodiments not involving immersion liquid, the irradiation of the selected portion 32 in at least one of the two steps is performed using EUV radiation. Irradiation may additionally be performed in one or more other steps using other forms of irradiation (with or without an immersion liquid), including DUV radiation.

For many deposition materials, it is necessary to perform the deposition process at an elevated temperature in order for the layer of deposited material to have a level of quality that is suitable for inclusion in a device (e.g. semiconductor device) being manufactured. For example, where the deposited material is required to form a highly conductive thin track, conductivity of the track must be suitably high. The elevated temperature provides the energy necessary for atoms in the deposited material to rearrange into a higher quality state (e.g. a more crystalline state).

In a class of embodiments, such high temperatures are avoided by including an additional step of annealing the deposited material to modify the deposited material. The modification may take various forms, including increasing a degree of crystallinity of the deposited material. For example, the annealing may comprise converting an amorphous material to a crystalline form of the material or increasing a grain size of a material that already has a degree of crystallinity. The irradiation to drive the deposition process and the annealing may be performed in sequence, one after the other. In an embodiment, the sequence is repeated to progressively build up multiple layers of the deposited material 30 in the selected portion 32.

The nature of the deposited material 30 is not particularly limited, as long as the deposited material 30 can be deposited in the manner described and subsequently annealed to modify the deposited material 30. In one class of embodiments, the material comprises, consists essentially of, or consists of carbon. In such embodiments, the modification of the material may comprise conversion of amorphous carbon into a crystalline form of carbon such as graphene or modification of the carbon to increase an average grain size of the carbon.

In an embodiment, the annealing of the deposited material is performed by irradiation with electromagnetic radiation. Annealing by such irradiation makes it possible to provide heating that is localized to the plane of the substrate W or even to a localized region within the substrate W. Temperatures suitable for effective annealing can thus be reached in localized regions where it is required, while temperatures elsewhere can be kept lower. Previously deposited layers can thus avoid reaching temperatures that would be high enough to damage the previously deposited layers (e.g. by causing melting).

In an embodiment, the same radiation source is used at different times to provide the irradiation to drive the deposition process and the irradiation to anneal the deposited material 30. In the example of Figure 5, for example, the same lithographic apparatus LA could be used to perform both the irradiation to drive the deposition process and the irradiation to anneal the deposited material 30.

In an embodiment, the irradiation of the selected portion 32 is performed with a finer spatial resolution at the substrate W than the irradiation to anneal the deposited material 30. In the case where a lithographic apparatus LA using EUV radiation is used, for example, EUV radiation may be applied through a patterning device MA (e.g. a mask) that patterns the EUV radiation and thereby defines the pattern of the layer of deposited material 30 to be formed. This approach achieves high levels of localization, sharp edges, pitch and critical dimension (CD). When the irradiation is applied to anneal the deposited material 30, the lithographic apparatus LA may illuminate the substrate W without a patterning device and/or with a different (lower resolution) patterning device and/or with the EUV radiation defocussed so as to spread over a larger area. Illumination without a patterning device is sometimes referred to as flood exposure. Annealing using such a flood exposure can increase throughput significantly relative to other modes of illumination.

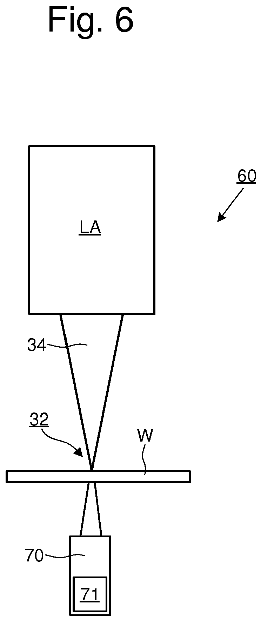

In a further class of embodiment, a first radiation source SO is used to provide the irradiation to drive the deposition process. A second radiation source 71 is used to anneal the deposited material 30. The first radiation source SO is different to the second radiation source 71. This approach allows each radiation source to be optimised for the respective process it is required to perform (i.e. driving the deposition process or annealing the deposited material 30). An example apparatus for implementing an embodiment of this type is depicted in Figure 6. In an embodiment, the first radiation source SO and the second radiation 71 source irradiate the substrate W from opposite sides of the substrate W. This approach provides greater flexibility for positioning hardware to implement the respective irradiation processes. An example of such an arrangement is depicted in Figure 6. In this embodiment, a first radiation source SO in a lithographic apparatus LA irradiates the selected portion 32 to define the pattern to be formed. A second radiation source 71 in a laser unit 70 (which is an example of an annealing system) irradiates the substrate W, from an opposite side of the substrate W to the deposited material 30, to provide the annealing of the deposited material 30. In this arrangement the annealing may be performed at the same time as the deposition process is being performed or at later time. In one embodiment, the annealing is performed on one portion of the substrate W while the deposition process is being applied to a different portion of the substrate W. The positioning of a laser spot to perform the annealing may thus positionally lag behind the progression of the irradiation to drive the deposition on the other side of the substrate W (i.e. to heat a portion of the substrate W that has been irradiated by the lithographic apparatus LA at an earlier time). In other embodiments, as in the example discussed above with reference to Figure 5 where the same lithographic apparatus LA is used both to perform the irradiation to drive the deposition process and the irradiation to anneal the deposited material 30, the radiation source used to anneal the deposited material 30 irradiates the substrate W from the same side of the substrate W as the deposited material 30.

In another class of embodiment, the annealing of the deposited material 30 comprises a first step and a second step. In the first step, all of the substrate W is preheated to a target temperature above room temperature. In the second step, subsequent to the first step, a selected local region of the substrate W is heated to a temperature above the target temperature. The second step may be repeated to heat other selected local regions. Each selected local region is smaller than the whole substrate W. In an embodiment, the target temperature is below the temperature needed to perform the annealing effectively and the localized irradiation in the second step locally heats each selected local region to a temperature that is effective for annealing. In an embodiment, the target temperature is below a temperature that would damage any previously deposited layers. The target temperature may thus depend on the nature of the previously deposited layers and/or, therefore, on the stage of a manufacturing process at which the deposition is to be performed. In an embodiment, the target temperature is less than 1000 degrees C. In an embodiment, the target temperature is less than 400 degrees C. In an embodiment, the target temperature is less than 200 degrees C. In an embodiment, the localized heating is at least partly provided by the irradiation used to drive the deposition process. In an embodiment, the localized heating is at least partly provided by irradiating the substrate W separately, for example using a separate radiation source as described above with reference to Figure 6.

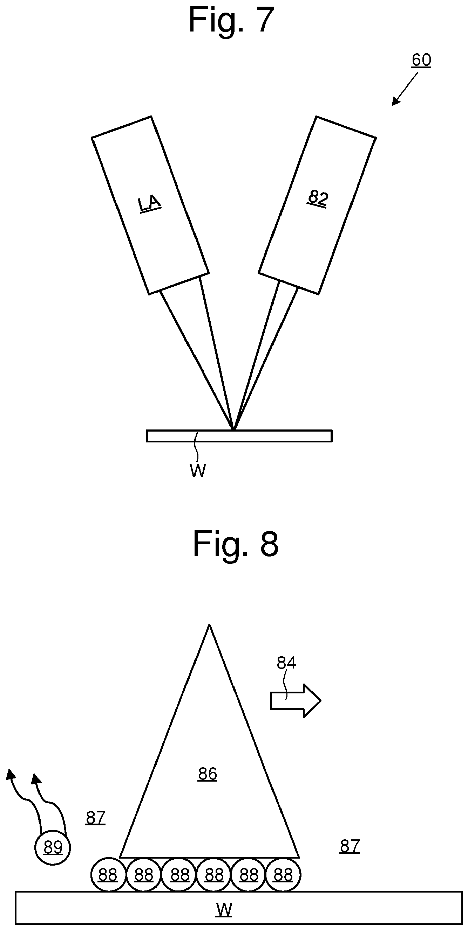

In a further class of embodiment, as depicted schematically in Figure 7, the irradiation of the selected portion 32 to drive the deposition process is performed using EUV radiation applied by a first irradiation system (e.g. having a wavelength of less than 100nm, optionally in the range of 5-100 nm, optionally within a range of 4 nm to 20 nm, for example 6.7 nm or 13.5 nm) in combination with one or more of the following applied by a second irradiation system during the driving of the deposition process: an electron beam; radiation having a wavelength in the range of 100nm to 400nm; and laser radiation. An apparatus 80 for implementing an embodiment in which the irradiation of the selected portion to drive the deposition process is performed using radiation having a wavelength of less than 100nm (supplied via a lithographic apparatus LA acting as the first irradiation system) in combination with an electron beam (supplied by an e-beam source 82 acting as the second irradiation system) is depicted schematically in Figure 7. The first irradiation system and the second irradiation system are configured such that the irradiation locally drives the deposition process in the selected portion 32 to cause formation of the layer of deposited material 30 in the pattern defined by the selected portion 32.

The driving of the deposition process by the EUV radiation often occurs predominantly by the EUV radiation interacting with solid material (e.g. the substrate W or layers formed on the substrate W) to liberate electrons from the solid material and thereby form a plasma. The plasma drives chemical reactions involved with the deposition process. Using an e-beam in combination with the EUV radiation provides a high concentration of electrons and/or further contributes to breaking bonds to create reactive species, thereby promoting faster deposition of material.

In an embodiment, the deposited material comprises, consists essentially of, or consists of, boron, optionally a monolayer of boron. In an example of such an embodiment, the modification of the deposited material 30 caused by the annealing comprises modification of the boron to become more crystalline, including transforming the boron into a borophene. In an embodiment, the borophene is formed directly by the irradiation of the selected portion 32. In embodiments of this type, the annealing may or may not be performed to improve the deposited material 30. In an embodiment of this type, the deposition process providing the deposited boron is driven by irradiating the selected portion 32 of the substrate with EUV radiation (e.g. having a wavelength of less than 100nm, optionally in the range of 5-100 nm, optionally within a range of 4 nm to 20 nm, for example 6.7 nm or 13.5 nm). As described above, the EUV radiation interacts with solid material to liberate electrons, which then act to drive the deposition process. In an embodiment, as depicted schematically in Figure 8, the irradiation is performed by scanning an EUV radiation beam 86 over the substrate W. In the schematic triangular region of the EUV radiation beam 86, particles 88 deposited on the surface of the substrate W are exposed to EUV radiation and to plasma created by the EUV radiation. The net effect in this region is to drive the deposition process, such that particles 88 are attached to the surface of the substrate W. Plasma 87 created by the EUV radiation beam 86 is present, however, in regions close to where the EUV radiation beam is scanning, for example in the wake of the EUV radiation beam 86. This plasma can act as an etchant and remove material that has recently been deposited by the EUV radiation beam 86. The detachment of particle 89 by such etching is depicted schematically in Figure 8 on the left-hand side of the EUV radiation beam 86, which is being scanned towards the right (arrow 84). In comparison with other materials, including carbon for example, boron is more transparent to EUV radiation and resistant to plasma-induced etching processes. The extent to which deposited material is lost due to etching is therefore reduced, thereby increasing a net rate of deposition. The resistance to etching allows scanning modes (instead of or in addition to stepping modes) to be used, which for other materials would cause loss of material due to plasma-induced etching to increase to unacceptable levels.

In an embodiment, a pattern in a patterned layer of material is at least partly defined by removing material instead of, or in addition to, selectively depositing material as described in any of the embodiments above. In such embodiments, a deposition process forms a layer of material. The deposition process may be performed in any of the ways described above, including using one or more of the following: atomic layer deposition; chemical vapor deposition; plasma-enhanced chemical vapor deposition; epitaxy; sputtering; and electron beam-induced deposition. A selected portion of the layer of material deposited is irradiated. In an embodiment, the layer of material covers all of an underlying layer or substrate prior to the irradiation (i.e. the layer of material comprises no pattern prior to irradiation). In other embodiments, the layer of material comprises a first pattern and the irradiation refines the first pattern to provide a second pattern, different from the first pattern. The radiation comprises an electron beam. In some embodiments, the radiation further comprises radiation of a different type, such as electromagnetic radiation. In an embodiment, the different type of radiation comprises UV radiation, DUV radiation, EUV radiation, or any combination of two or more of UV, DUV and EUV radiation. The irradiation is such as to cause removal of the layer of material in the selected portion and thereby form a layer of material in a pattern defined by the selected portion. In an embodiment the irradiation is performed in the presence of either or both of hydrogen and a hydrogen-plasma over at least the selected portion being irradiated. The combination of the irradiation and the hydrogen and/or hydrogen-plasma causes etching away of the layer of material (which may comprise solid and/or liquid material) selectively in the selected portion (i.e. etching occurs in the selected portion and not in areas outside of the selected portion).

In an of the above-described methods of forming a patterned layer of material, the patterned layer of material can comprise final material that will be present in the device being manufactured (e.g. an IC device). The final material may, for example, comprise a two-dimensional material, such as one or more of the following: graphene, hexagonal boron nitride (hBN), and transition metal dichalcogenides (TMD). Alternatively or additionally, the patterned layer of material can comprise an auxiliary pattern that will contribute functionally to one or more subsequent manufacturing steps. In an embodiment, the auxiliary material functions as a hard mask (when formed from amorphous C for example). In an embodiment, the auxiliary material functions as a material enhancing photo-electron yield (when comprising Sn, In and/or one or more of their compounds for example). In an embodiment, the auxiliary material functions as a precursor and/or co-reactant and/or catalyst (e.g. metals and their compounds) for one or more subsequent deposition steps.

The embodiments may further be described using the following clauses:
1. A method of forming a patterned layer of material, comprising:
   irradiating a selected portion of a surface of a substrate during a deposition process, the irradiation being such as to locally drive the deposition process in the selected portion and thereby form a layer of deposited material in a pattern defined by the selected portion; and
   annealing the deposited material to modify the deposited material.
2. The method of clause 1, wherein the deposition process is configured to form a monolayer.
3. The method of clause 2, wherein the irradiation to drive the deposition process and the irradiation to anneal are performed in sequence and the sequence is repeated to progressively build up multiple monolayers of the deposited material in the selected portion.
4. The method of any preceding clause, wherein the annealing of the deposited material comprises:
   a first step in which all of the substrate is preheated to a target temperature above room temperature; and
   a second step, subsequent to the first step, in which a selected local region of the substrate is heated to a temperature above the target temperature, the selected local region being smaller than the whole substrate.
5. The method of any preceding clause, wherein:
   a first radiation source is used to provide the irradiation to drive the deposition process;
   a second radiation source is used to anneal the deposited material; and
   the first radiation source is different to the second radiation source.
6. The method of clause 5, wherein the first radiation source and the second radiation source irradiate the substrate from opposite sides of the substrate.
7. The method of clause 5, wherein the first radiation source and the second radiation source irradiate the substrate from the same side of the substrate.
8. The method of any of clauses 1 to 4, wherein the same radiation source is used at different times to provide the irradiation to drive the deposition process and irradiation to anneal the deposited material.
9. The method of clause 8, wherein the irradiation to drive the deposition process is performed with a finer spatial resolution than the irradiation to anneal the deposited material.
10. The method of clause 8 or 9, wherein the irradiation to drive the deposition process and the irradiation to anneal the deposited material use radiation having a wavelength of less than 100nm.
11. The method of any of clauses 8 to 10, wherein the irradiation to drive the deposition process is performed using a patterning device to pattern a radiation beam and thereby define the pattern of the layer of deposited material and the irradiation to anneal the deposited material is performed using a different patterning device or no patterning device.
12. The method of any preceding clause, wherein the modification of the deposited material comprises increasing a degree of crystallinity of the deposited material.
13. The method of any preceding clause, wherein the irradiation to drive the deposition process is performed using electromagnetic radiation having a wavelength of less than 100nm.
14. The method of any preceding clause, wherein the deposited material comprises carbon.
15. The method of any of clauses 1 to 13, wherein the deposited material comprises boron.
16. The method of any preceding clause, wherein:
   the irradiation to drive the deposition process is performed using radiation having a wavelength of less than 100nm in combination with one or more of the following: an electron beam; radiation having a wavelength in the range of 100nm to 400nm; and laser radiation.
17. A method of forming a patterned layer of material, comprising:
   irradiating a selected portion of a surface of a substrate during a deposition process, the irradiation being such as to locally drive the deposition process in the selected portion and thereby form a layer of deposited material in a pattern defined by the selected portion, wherein:
   the irradiation is performed using radiation having a wavelength of less than 100nm in combination with one or more of the following: an electron beam; radiation having a wavelength in the range of 100nm to 400nm; and laser radiation.
18. A method of forming a patterned layer of material, comprising:
   irradiating a selected portion of a surface of a substrate with electromagnetic radiation having a wavelength of less than 100nm during a deposition process, the irradiation being such as to locally drive the deposition process in the selected portion and thereby cause the deposition process to form a layer of material in a pattern defined by the selected portion,
   wherein the deposited material comprises boron.
19. The method of clause 18, wherein the irradiation of the selected portion is performed by scanning a radiation beam over the substrate.
20. A method of forming a patterned layer of material, comprising:
   using a deposition process to form a layer of material; and
   irradiating a selected portion of the layer of material with radiation comprising an electron beam, the irradiation being such as to cause removal of the layer of material in the selected portion and thereby form a layer of material in a pattern defined by the selected portion.
21. The method of clause 20, wherein the irradiation is performed in the presence of either or both of hydrogen and a hydrogen plasma over at least the selected portion being irradiated.
22. The method of any preceding clause, wherein the deposition process comprises one or more of the following: atomic layer deposition; chemical vapor deposition; plasma-enhanced chemical vapor deposition; epitaxy; sputtering; and electron beam-induced deposition.
23. A method of forming a semiconductor device, comprising using the method of any preceding clause to form at least one layer in the device.
24. An apparatus for forming a patterned layer of material, comprising:
   an irradiation system configured to irradiate a selected portion of a surface of a substrate during a deposition process, the irradiation being such as to locally drive the deposition process in the selected portion and thereby form a layer of deposited material in a pattern defined by the selected portion; and
   an annealing system configured to anneal the deposited material to modify the deposited material.
25. An apparatus for forming a patterned layer of material, comprising:
   a first irradiation system configured to irradiate a selected portion of a surface of a substrate during a deposition process with radiation having a wavelength of less than 100nm; and
   a second irradiation system configured to irradiate the selected portion of the surface of the substrate during the deposition process with one or more of the following: an electron beam; radiation having a wavelength in the range of 100nm to 400nm; and laser radiation, wherein:
      the first irradiation system and the second irradiation system are configured such that the irradiation locally drives the deposition process in the selected portion to cause formation of a layer of deposited material in a pattern defined by the selected portion.
26. The apparatus of clause 24 or 25, wherein each irradiation system comprises a lithographic apparatus configured to provide the irradiation of the selected portion by projecting a patterned radiation beam from a patterning device onto the substrate.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

While specific embodiments of the invention have been described above, it will be appreciated that the invention may be practiced otherwise than as described. The descriptions above are intended to be illustrative, not limiting. Thus, it will be apparent to one skilled in the art that modifications may be made to the invention as described without departing from the scope of the claims set out below.

## Claims

1. A method of forming a patterned layer of material, comprising:
irradiating a selected portion of a surface of a substrate during a deposition process, the irradiation being such as to locally drive the deposition process in the selected portion and thereby form a layer of deposited material in a pattern defined by the selected portion; and
annealing the deposited material to modify the deposited material.

2. The method of claim 1, wherein the deposition process is configured to form a monolayer.

3. The method of claim 2, wherein the irradiation to drive the deposition process and the irradiation to anneal are performed in sequence and the sequence is repeated to progressively build up multiple monolayers of the deposited material in the selected portion.

4. The method of claim 1, wherein the annealing of the deposited material comprises:
a first step in which all of the substrate is preheated to a target temperature above room temperature; and
a second step, subsequent to the first step, in which a selected local region of the substrate is heated to a temperature above the target temperature, the selected local region being smaller than the whole substrate.

5. The method of claim 1, wherein:
a first radiation source is used to provide the irradiation to drive the deposition process;
a second radiation source is used to anneal the deposited material; and
the first radiation source is different to the second radiation source.

6. The method of claim 1, wherein the same radiation source is used at different times to provide the irradiation to drive the deposition process and irradiation to anneal the deposited material.

7. The method of claim 6, wherein the irradiation to drive the deposition process is performed with a finer spatial resolution than the irradiation to anneal the deposited material.

8. The method of claim 6, wherein the irradiation to drive the deposition process is performed using a patterning device to pattern a radiation beam and thereby define the pattern of the layer of deposited material and the irradiation to anneal the deposited material is performed using a different patterning device or no patterning device.

9. The method of claim 1, wherein the modification of the deposited material comprises increasing a degree of crystallinity of the deposited material.

10. The method of claim 1, wherein the irradiation to drive the deposition process is performed using electromagnetic radiation having a wavelength of less than 100nm.

11. The method of claim 1, wherein the deposited material comprises carbon.

12. The method of claim 1, wherein the deposited material comprises boron.

13. The method of claim 1, wherein:
the irradiation to drive the deposition process is performed using radiation having a wavelength of less than 100nm in combination with one or more of the following: an electron beam; radiation having a wavelength in the range of 100nm to 400nm; and laser radiation.

14. An apparatus for forming a patterned layer of material, comprising:
an irradiation system configured to irradiate a selected portion of a surface of a substrate during a deposition process, the irradiation being such as to locally drive the deposition process in the selected portion and thereby form a layer of deposited material in a pattern defined by the selected portion; and
an annealing system configured to anneal the deposited material to modify the deposited material.

15. The apparatus of claim 14, wherein each irradiation system comprises a lithographic apparatus configured to provide the irradiation of the selected portion by projecting a patterned radiation beam from a patterning device onto the substrate.
